# EUROPÄISCHE PATENTSCHRIFT

(11) **EP 0 700 454 B1**
(45) Veröffentlichungstag und Bekanntmachung des Hinweises auf die Patenterteilung: **22.07.1998**
(21) Anmeldenummer: 94915036.1
(22) Anmeldetag: 16.05.1994
(51) Int. Cl.: C30B 11/00, C30B 29/12

(54) **VERFAHREN ZUR HERSTELLUNG GROSSFLÄCHIGER KRISTALLINER SALZKÖRPER UND DAZU GEEIGNETE VORRICHTUNG**
PROCESS AND DEVICE FOR PRODUCING LARGE-SURFACE CRYSTALLINE SALT PLATES
PROCEDE ET DISPOSITIF DE FABRICATION DE PLAQUES A LARGE SURFACE EN SELS CRISTALLINS

(30) Priorität: 25.05.1993 DE 4317379; 22.09.1993 DE 4332535
(43) Veröffentlichungstag der Anmeldung: 13.03.1996
(73) Patentinhaber: SIEMENS MEDICAL SYSTEMS, INC., Iselin, New Jersey 08830 (US)
(72) Erfinder: BERTHOLD, Thomas, D-80935 München (DE)
(74) Vertreter: Epping, Wilhelm, Dr.-Ing.
(86) Internationale Anmeldenummer: DE9400567
(87) Internationale Veröffentlichungsnummer: WO9428205

(56) Entgegenhaltungen:
- EP-A- 0 338 411
- DE-C- 4 002 320
- US-A- 4 038 201
- US-A- 5 178 719

## Beschreibung

In der Nuklearmedizin werden für die Anger-Kamera zur Detektion von Gammastrahlung große Szintillatorplatten aus mit Thallium dotiertem Natriumiodid benötigt. Mit diesen Detektoren wird die Verteilung von radioaktiv markierten Substanzen im menschlichen Körper beobachtet, die dem Körper vorher zugeführt werden. Die Veränderung bzw. die Ansammlung der radioaktiv markierten Stoffe kann Aufschluß über Stoffwechselvorgänge und über besonders aktive lokale Krankheitsherde, zum Beispiel über Krebsgeschwüre geben. Bei den bisherigen Anwendungen der Anger-Kamera werden als Szintillatorplatten rechteckige oder runde Platten mit Abmessungen bis zu 40 x 60 cm² bzw. bis zu 60 cm Durchmesser bei einer Dicke von 10 bis 12 mm benötigt.

Nachteilig an Detektoren dieser Abmessungen ist, daß stets nur ein bestimmter Abschnitt vom Körper des Patienten in einer Untersuchung beobachtet werden kann. Für bestimmte medizinische Untersuchungen ist es aber von Vorteil, wenn die Verteilung radioaktiv markierter Substanzen bzw. Pharmaka im Körper des Patienten durch eine Ganzkörperaufnahme abgebildet werden kann. Damit könnten Funktionen untersucht werden, die den gesamten Körper umfassen, beispielsweise arterielle, nervöse und lymphatische Systeme, ohne daß eine mehrmalige Zufuhr der mit kurzlebigen Radionukliden markierten Substanzen erforderlich ist, die eine starke Strahlenbelastung des Patienten zur Folge haben. Ein weiteres Problem ist, daß die Abbildung durch Reflexionen am Rand der Szintillatorplatte stark beeinflußt wird. Auch hier ist eine große Szintillatorplatte günstiger, bei der der reflektierende Rand möglichst weit von dem mit γ-Strahlung getroffenen Bereicn der Platte entfernt ist.

In der deutschen Patentschrift DE 40 02 320 C2 wird vorgeschlagen, als Leuchtstoff geeignete Salzkörper aus dotieren Alkalihalogeniden durch Erstarrenlassen einer dotierten Salzschmelze zu erzeugen. Dazu wird die Salzschmelze unmittelbar nach der Zugabe des als Dotierstoff zugesetzten flüchtigen Talliumhalogenids rasch so weit abgekühlt, bis zumindest die Schmelzenoberfläche erstarrt ist. Der nach vollständiger Abkühlung erhaltene Salzkörper kann nur durch Zerstörung des Schmelztiegels bzw. der Gießform von dieser gelöst werden, da die Alkalihalogenide beim Erstarren auf vielen Materialien außerordentlich gut haften. Da aber die zur Aufnahme einer Alkalihalogenidschmelze geeigneten inerten Materialien wie beispielsweise Quarzglas, Graphit oder Edelmetalle relativ teure Materialien darstellen, führt der Verlust der Gießform nach dem Herstellen der Salzkörper zu einer wesentlichen Verteuerung des Verfahrens. Außerdem ist eine Nachbearbeitung sämtlicher Oberflächen des erhaltenen Salzkörpers erforderlich.

Für die herkömmlichen Szintillatorplatten werden zunächst klare, blasenfreie Blöcke aus NaI:T1 hergestellt. Nach dem Bridgeman-, Stockbarger- oder Czochralski-Verfahren werden Einkristalle erhalten, während durch Strangpressen polykristalline Blöcke erzeugt werden können. Weil alle diese Blöcke nur in begrenzten Abmessungen hergestellt werden können, müs-sen sie zur Herstellung großflächiger Platten in einem zusätzlichen Arbeitsgang durch Pressen bei Temperaturen über 300°C auf den gewünschten Durchmesser hin warmverformt werden. Dies stellt ein technisch aufwendiges Verfahren dar und ist außerdem nicht dazu geeignet, Szintillatorplatten mit Abmessungen von 60 x 200 cm² zu erzeugen, welche für Ganzkörperuntersuchungen erforderlich wären.

Aus der US-A-5 178 719 ist eine Vorrichtung zum Herstellen großer Alkalihalogenidkristalle nach dem Bridgman-Stockbarger-Verfahren bekannt. In dieser Vorrichtung wird eine Schmelze entlang eines Temperaturgradienten bewegt, bis eine Kristallisation einsetzt.

Aus der US-A-4 038 201 ist eine Vorrichtung zur Herstellung polykristalliner Körper bekannt, bei der eine Schmelze durch kontrollierte Abkühlung einer gerichteten Erstarrung unterworfen wird.

Aufgabe der vorliegenden Erfindung ist es daher, ein Verfahren zur Herstellung eines polykristallinen Salzkörpers anzugeben, welches einfacher und kostengünstiger als bekannte Verfahren durchzuführen ist und trotzdem zu optisch klaren Kristallkörpern ohne Trübungen, Risse und dergleichen führt.

Diese Aufgabe wird erfindungsgemäß gelöst durch ein Verfahren mit den Merkmalen von Anspruch 1.

Weitere Ausgestaltungen der Erfindung sowie eine zur Ausführung des erfindungsgemäßen Verfahrens geeignete Vorrichtung sind den übrigen Ansprüchen zu entnehmen.

Ein wesentliches Merkmal des erfindungsgemäßen Verfahrens ist die vorgegebene Temperaturdifferenz zwischen der Schmelze im Schmelztiegel bzw. dem Schmelzpunkt des Salzes und dem Boden der Gießform, die ausreichend groß sein muß, um die gewünschte "Abschreckung" der Schmelze in der Gießform zu erzielen. Überraschend wurde gefunden, daß bereits ein Temperaturunterschied von 1-50°C für diesen Zweck ausreichend ist. Dies führt zu einer unmittelbaren Krustenbildung in der Gießform. Durch die Kruste wird die Gießform vor dem Angriff der chemisch aggressiven Salzschmelze geschützt, da diese praktisch nicht mit der Gießform in Kontakt treten kann. Demzufolge ist auch die Materialauswahl zum Herstellen der Gießform nicht mehr auf jene teuren und inerten Materialien beschränkt, die in bisherigen Versuchen und Verfahren beim Umgang mit Salzschmelzen erforderlich waren, um eine Verunreinigung des Salzkörpers durch Tiegel- oder Gießformmaterial zu verhindern.

Weiterhin verhindert die sich unmittelbar bildende Kruste ein Einsickern der Schmelze in eventuell vorhandene Fugen der Gießform. Dadurch wird es möglich, die Gießform aus mehreren Teilen aufzubauen, bzw. den Aufbau der Gießform wieder zerlegbar zu gestalten. Dadurch kann der Salzkörper nach dem Erstarren durch Zerlegen der mehrteiligen Gießform in einfacher Weise freigelegt werden. Die problemlose Entformung des Salzkörpers ohne Zerstörung der Gießform ist insbesondere dann von Vorteil, wenn mit dem Verfahren größere Salzkörper erzeugt werden, die ein Gewicht von bis zu mehreren 100 Kilogramm besitzen können.

Ein Verfahren, bei eine Siliziumschmelze in eine aus Graphit bestehende Form gegossen wird, innerhalb der ein Temperaturgradient von mindestens 200°C eingestellt ist, ist z.B. aus der DE 25 08 803 Al bekannt. Nach dem Erstarren lassen in der von Silizium nicht benetzbaren Form werden für Solarzellen taugliche Siliziumplatten erhalten. Wegen der Nichtbenetzbarkeit der Form, der besseren Entformbarkeit und Handhabbarkeit der Siliziumwafer gegenüber einem z.B. aus einem Leuchtstoff bestehenden Salzkörper, für den eine hohe optische Qualität gefordert ist, ist dieses Verfahren mit dem erfindungsgemäßen Verfahren nicht vergleichbar. Das Siliziumgießverfahren wird im Vakuum durchgeführt.

Mit dem erfindungsgemäßen Verfahren können Salzkörper von nahezu beliebiger Größe hergestellt werden, da das Problem der beim Abkühlen auftretenden mechanischen Verspannungen aufgrund unterschiedlicher Wärmeausdehnung von Gießform und Salzkörper entfällt, insbesondere weil der Salzkörper kaum oder gar nicht an der Gießform anhaftet. Bei bekannten Verfahren führten diese Verspannungen zu einer erhöhten Bruchgefahr oder zum Auftreten von Rissen in Salz körper und/oder Gießform.

Da die Gießform weder durch die Salzschmelze angegriffen wird, noch beim Entformen des Salzkörpers zerstört werden muß, kann sie beliebig oft wiederverwendet werden, wodurch sich ein weiterer Kostenvorteil des Verfahrens ergibt.

Möglich ist es auch, anstelle einer ebenen Gießform auch eine solche zu verwenden, deren Boden ein Profil aufweist. Damit können Salzkörper mit einer gewünschten Oberflächenstruktur erzeugt werden. Denkbar ist zum Beispiel eine im Bodenbereich gewölbte Gießform, mit welcher die Erzeugung einer Linse aus dem Salzkörper möglich bzw. erleichtert wird. Durch in der Gießform vorgegebene V-förmige Vertiefungen ist die Herstellung von Fresnel-Linsen möglich. Doch auch mit einer besonderen Formgebung im Randbereich kann der Salzkörper bereits für eine spätere Verwendung vorgeformt werden. Möglich ist zum Beispiel die Herzeugung von Stufen, Rillen oder Nuten, die ein Befestigen des Salzkörpers in einer Vorrichtung ermöglichen.

Beim Erstarren wächst der polykristalline Salzkörper vorzugsweise von unten nach oben. Diese gerichtete Erstarrung führt zu Kristallen von hoher Qualität und optischer Reinheit mit großen Korndurchmessern, die bereits in nicht optimierten Verfahren mehr als 10 cm erreichen.

Mit dem Verfahren können Salzkörper mit innerhalb der thermodynamischen Mischbarkeitsgrenzen liegender beliebiger Zusammensetzung erzeugt werden, vorzugsweise jedoch aus dotierten Alkalihalogeniden, die beispielsweise in Form großer Leuchtstoffplatten von ca. 60 cm Durchmesser und 10 bis 12 mm Dicke für die Angerkamera benötigt werden. Bevorzugtes Material ist dabei ein mit Thallium dotiertes Natriumiodid. Doch auch andere Alkalihalogenide beispielsweise Cäsiumiodid sowie andere Dotierstoffe, beispielsweise Wismutverbindungen oder solche der seltenen Erden können im erfindungsgemäßen Verfahren verwendet werden.

In einer Ausgestaltung der Erfindung wird das Aufschmelzen des Ausgangsmaterials und das Einbringen in die Gießform kontinuierlich durchgeführt. Bereits geschmolzenes Salz wird unmittelbar aus dem Schmelztiegel in die Gießform überführt, was in einfacher Weise durch Auslaßöffnungen im Boden des über der Gießform angeordneten Schmelztiegels erfolgen kann. In einfacher Weise können so Schmelztiegel und Gießform zu einer einheitlichen Vorrichtung verbunden werden, die nach dem Einbringen des Ausgangsmaterials in den Schmelztiegel keines äußeren Eingriffs mehr bedarf. Dies hat den weiteren Vorteil, daß die Salzschmelze nicht auf eine zu hohe Temperatur erhitzt wird, bei der ein Abdampfen der gegebenenfalls im Salz enthaltenen flüchtigen Dotierstoffe erfolgen kann.

Die Vorrichtung kann zum Fahren eines Temperaturprogramms für Aufschmelzen und Abkühlen in einen Ofen eingestellt werden, wobei nur noch eine Kühlung des Bodens der Gießform erforderlich ist. Dazu wird eine Kühlgasleitung von außen in den Ofen eingeführt und ein Kühlgasstrom gegen den Boden der Gießform geblasen. Die Temperatur von Schmelztiegel und Gießform wird dabei von außen überwacht und über die Ofentemperatur bzw. den Kühlgasstrom gesteuert. Während des Aufschmelz- bzw. Erstarrungsprozesses des als Ausgangsmaterials verwendeten Salzes wird für den Schmelztiegel eine über dem Schmelzpunkt des Salzes liegende Temperatur und für den Boden der Gießform eine 1 bis 50°C unter dem Schmelzpunkt liegende Temperatur eingestellt.

Da einige der Alkalihalogenide stark hygroskopisch sind, wird das Verfahren vorzugsweise unter einer trockenen Inertgasatmosphäre durchgeführt. Dabei ist es möglich, die zumindest aus Schmelztiegel und Gießform bestehende Vorrichtung gasdicht abzudichten. Möglich ist es auch, mittels einer Spülgasleitung einen schwachen Inertgasstrom durch die Vorrichtung einzustellen. Sofern in der Vorrichtung brennbare und beispielsweise aus Graphit bestehende Materialien verwendet werden, wird vorzugsweise unter einer sauerstofffreien Atmosphäre gearbeitet, um eine Oxidation von Vorrichtungsteilen zu verhindern.

In einer weiteren Ausgestaltung der Erfindung werden vor dem Einbringen der Salzschmelze am Boden der Gießform zumindest zwei kristalline block- oder plattenförmige Salzplatten, die eine den Salzkörpern entsprechende Zusammensetzung aufweisen, nebeneinander derart angeordnet, daß Fugen von geringer Breite dazwischen verbleiben. Anschließend werden die Salzplatten mit der Salzschmelze übergossen, bis zumindest die Fugen mit Salzschmelze gefüllt sind.

Bei dem neuen Verfahren werden zum Beispiel aus NaI:T1 bestehende Salzplatten, die mit einem der genannten herkömmlichen Verfahren hergestellt wurden, zu großflächigen polykristallinen Salzkörpern verbunden, indem eine Schmelze der gleichen oder ähnlicher Zusammensetzung in die Fugen zwischen die festen Teile gegossen wird und dort erstarrt. Dabei kann auch ein Vergleich zur einfachsten Ausführung der Erfindung niedrigerer Temperaturunterschied der Gießform zur Schmelztemperatur von 1-50°C eingestellt werden.

Die als Ausgangsmaterial verwendeten Salzplatten können beliebig klein gewählt werden und daher einfach und kostengünstig hergestellt werden. Die Kristallgüte der Salzplatten bestimmt auch die Kristallgüte der erzeugten großflächigen Salzkörper, bei denen entweder die ursprünglichen Fugen zwischen den Salzplatten in der fertigen Salzplatte optisch nicht mehr zu erkennen sind oder gezielt zur optischen Strukturierung benützt werden. Es werden also mechanisch fugenlose, klare und blasenfreie Salzkörper erhalten, deren Güte zur Herstellung von Szintillatorplatten für die Anger-Kamera geeignet ist. Von Vorteil ist außerdem, daß die Salzkörper beliebig großflächig und in beliebiger Form bzw. im beliebigen Grundriß hergestellt werden können. Durch geeignete Dotierstoffe in der Schmelze können Platten mit einer strukturierten Verteilung ihrer optischen Eigenschaften (Brechungsindex, Transparenz) hergestellt werden.

Im folgenden wird die ebenfalls erfindungsgemäße Vorrichtung zur Durchführung des Verfahrens anhand von Ausführungsbeispielen und der dazugehörigen elf Figuren näher erläutert.
Die Figuren 1 - 4 zeigen im schematischen Querschnitt eine erfindungsgemäße Vorrichtung während verschiedener Stufen eines ersten Ausführungsbeispiels,
Figur 5 zeigt eine zweite erfindungsgemäße Vorrichtung, die eine zylinderförmige Gießform umfaßt,
die Figuren 6 - 10 zeigen eine Vorrichtung während einer weiteren Ausführungsvariante, während
Figur 11 eine weitere Ausführungsvariante mit einer zylinderförmige Gießform darstellt.

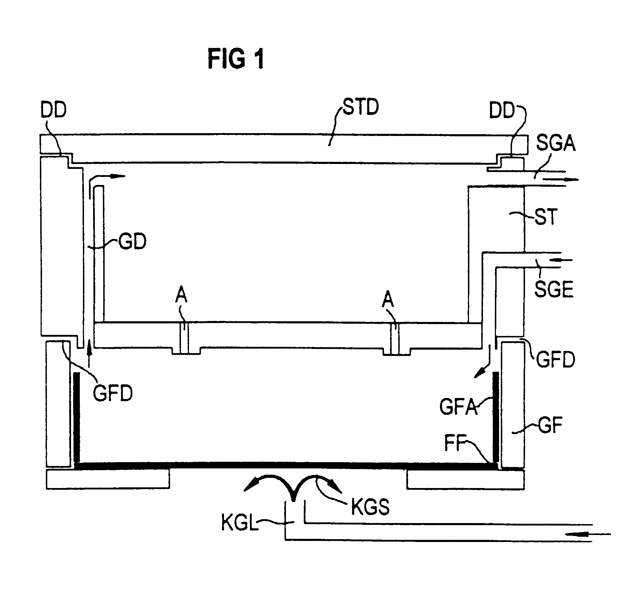

Figur 1 zeigt eine Ausführungsform der erfinsungsgemäßen Vorrichtung im schematischen Querschnitt. Im wesentlichen besteht die Vorrichtung aus drei Teilen, nämlich der Gießform GF, dem Schmelztiegel ST und dem Schmelztiegeldeckel STD. Die Vorrichtung kann eine runde, eine rechteckige oder eine beliebige andere Grundfläche besitzen, die in Abhängigkeit von der gewünschten Form des zu erzeugenden Salzkörpers gewählt wird. Die drei genannten Vorrichtungsbestandteile sind vorzugsweise so ausgebildet, daß sie sicher übereinander gestapelt werden können. Die Teile können dazu an den Berührungsflächen jeweils ein Profil aufweisen, das sich paßgenau in das Profil des darüber gestapelten Teils einfügen läßt. Zusätzlich können Dichtmittel zwischen jeweils zwei übereinander gestapelten Teilen vorgesehen sein, um das innere freie Volumen der Vorrichtung gasdicht nach außen abzudichten.

Die Gießformdichtung GFD kann zusätzlich wärmeisolierend ausgebildet sein, um die Temperaturdifferenz während des laufenden Verfahrens zwischen dem Schmelztiegel und der kühleren Gießform ohne Wärmebrücke aufrecht zu erhalten.

Der Schmelztiegel ST ist aus einem gegenüber der Salzschmelze inerten Material gefertigt und besteht beispielsweise aus Graphit oder einem Edelmetall. Im Boden des Schmelztiegels ST sind Auslaßöffnungen A vorgesehen, die ein Ablaufen der im Schmelztiegel sich bildenden Schmelze in die Gießform ermöglichen. Die Gießform GF selbst kann aus einem beliebigen, vorzugsweise jedoch gut wärmeleitenden Material bestehen, beispielsweise aus Graphit oder Edelstahl. Im Inneren ist die Gießform GF mit einer Auskleidung GFA versehen, die beispielsweise aus mehreren nebeneinander liegenden Glaskohlenstoffplatten bestehen kann. Zwischen den einzelnen Platten der Auskleidung verbleibende Fugen FF stören nicht, wenn sie nicht breiter als ca. 0,2 mm sind. Breitere Fugen können gegebenenfalls mit einer graphithaltigen Abdichtpaste ausgefüllt werden. Möglich ist es beispielsweise auch, die Auskleidung GFA aus Edelmetall oder einem anderen geeigneten Material herzustellen.

Weitere wichtige Merkmale der Vorrichtung sind die Gasdurchführung GD, die das freie Volumen des Schmelztiegels ST mit dem der Gießform GF verbindet, und die Durchführung SGA, die gegebenenfalls über Filter, Gaswäscher oder Pumpen die Verbindung zur Außenatmosphäre darstellt. Die Durchführung SGA verhindert beim Aufblasen der gasdichten Vorrichtung einen Überdruck durch das sich erwärmende eingeschlossene Gas. Durch Pumpen ist es möglich innerhalb der Vorrichtung einen leichten Unterdruck einzustellen, um bei leichten Leckagen ein Austreten von giftigem Material zu verhindern. Durch Gaswäscher und Filter können die Dämpfe des Salzes und der Dotierstoffe aus dem Abgas entfernt werden. Die Gasdurchführung GD dient dem Druckausgleich innerhalb der Vorrichtung beim Abfließen der Schmelze aus dem Schmelztiegel ST durch die Auslaßöffnungen A. Optional können noch weitere Gasdurchführungen vorgesehen sein, beispielsweise ein Spülgaseinlaß SGE, um die im übrigen nach außen abgedichtete Vorrichtung mit einem inerten Spülgas zu spülen, zum Beispiel mit trockenem Stickstoff.

Durch geeignete Maßnahmen ist der Boden der Gießform GF kühlbar gestaltet. In der Figur ist dies beispielsweise an der zu kühlenden Stelle durch einen in der Dicke reduzierten Boden der Gießform dargestellt. An dieser Stelle wird ein über interne oder externe Kühlgasleitungen KGL herbeigeführter Kühlgasstrom KGS gegen den Boden der Gießform GF geblasen.

In den Schmelztiegel ST wird nun Ausgangsmaterial AM eingefüllt. Dieses besteht aus dem Salz der gewünschten Zusammensetzung in beliebiger Form (Pulver, Granulat, Stücke). Das Salz kann bereits mit einem für Leuchtstoffanwendungen geeigneten Dotierstoff dotiert sein, oder wird zusammen mit dem Dotierstoff als Mischung im Schmelztiegel vorgelegt. Für eine Anwendung wird mit Thalliumiodid dotiertes Natriumiodid als Ausgangsmaterial AM verwendet. Aufgrund der Flüchtigkeit des Thalliumhalogenids ist es in diesem Fall besonders wichtig, daß der Deckel (STD,D) über dem Schmelztiegel ST und die Gießform GF möglichst dicht aufeinander sitzen, um ein Austreten des giftigen Thalliumhalogenids während des Aufheizens zu verhindern. Bei geeignet gewählten Dichtmitteln DD und GFD ist es dabei möglich, innerhalb der Vorrichtung während des ganzen Verfahrens einen Druck von 0,8 bis zum zweifachen des normalen Außendrucks über Spülgasleitungen aufrechtzuerhalten.

Zur Durchführung des Temperaturprogramms zum Aufschmelzen des Ausgangsmaterials AM und auch während des Abkühlens wird die gesamte Vorrichtung in einen Ofen eingestellt. Der Ofen wird anfangs auf eine über dem Schmelzpunkt des Salzes liegende Temperatur aufgeheizt. Beim Erreichen einer vorgegebenen, ca. 50 ° unter dem Schmelzpunkt des Salzes liegenden Temperatur wird mit der Kühlung der Gießform GF bzw. deren Boden begonnen und dazu ein Kühlgasstrom gegen den Boden geblasen. Die Temperatur der Gießform GF und des Schmelztiegel ST wird dabei mittels Temperatursensoren, beispielsweise mit Nikkel/Chrom/Nickel-Thermoelementen überwacht. Die Temperatur des Bodens sollte dabei auf einem Wert gehalten werden, der 1-50°C unter dem Schmelzpunkt des Ausgangsmaterials liegt. Hat der Schmelztiegel die Schmelztemperatur des Salzes überschritten, beginnt das Ausgangsmaterial aufzuschmelzen und über die im Boden des Schmelztiegels ST angeordneten Auslaßöffnungen A in die darunterliegende Gießform GF abzutropfen bzw. abzulaufen.

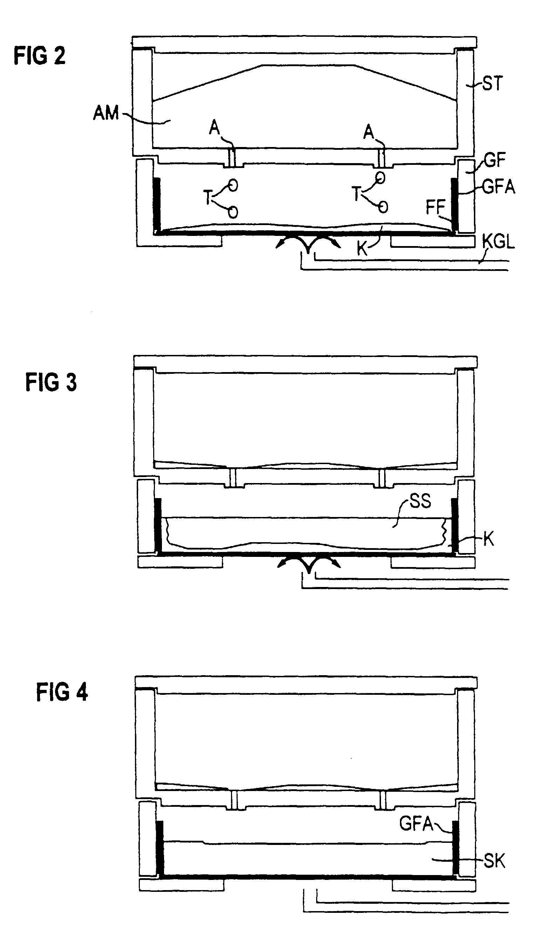

Figur 2 zeigt die Vorrichtung unmittelbar nach dem Einsetzen des Aufschmelzens des Ausgangsmaterials AM. Die auf dem kühleren Boden der Gießform GF auftreffenden Tropfen T haben dort durch sofortige Erstarrung bereits zur Ausbildung einer den Boden der Gießform GF bzw. der Gießformauskleidung GFA bedeckenden Kruste K geführt. Diese führt zu einer sofortigen Abdichtung von gegebenenfalls in der Gießformauskleidung bzw. der Gießform vorhandenen Fugen FF. Die wegen der Übersichtlichkeit nicht mehr dargestellten Gasdurchführungen GD sorgen für einen Druckausgleich zwischen Gießform GF und Schmelztiegel ST, um ein ungestörtes Abfließen der Salzschmelze in die Gießform GF durch die Auslaßöffnungen A zu ermöglichen.

Nach dem Ausbilden der Kruste K und nach weiterem Nachfließen bzw. Nachtropfen von Schmelze auf die Kruste bleibt ein Großteil der Schmelze über der Kruste stehen. Die Temperatur und damit die Geschwindigkeit des Aufschmelzens wird dabei so geregelt, daß die Kruste im weiteren Verlauf möglichst vollständig von Schmelze bedeckt ist, um ein durch Sublimation hin zur festen Kruste beschleunigtes Wachstum des Salzkörpers an den (kühleren) Rändern der Gießform zu unterdrücken.

Figur 3 zeigt die Vorrichtung nachdem sämtliches Ausgangsmaterial aufgeschmolzen und in die Gießform GF abgelaufen ist. Gut zu erkennen ist, daß noch nicht erstarrte Salzschmelze SS über der bereits erstarrten Kruste K des sich ausbildenden Salzkörpers steht. Auch ohne Veränderung der einmal eingestellten Temperaturverhältnisse in der Vorrichtung wächst der Salzkörper nun von der Kruste K ausgehend im wesentlichen durch Erstarrung nach oben.

Figur 4 zeigt die Vorrichtung in einem Stadium, in dem die Schmelze in der Gießform GF bereits vollständig erstarrt ist und einen durchgehenden Salzkörper SK ausgebildet hat. Wegen der Volumenkontraktion beim Übergang vom flüssigen in den festen Zustand entsteht an der Oberseite der Salzplatte eine Mulde oder eine mit Hohlräumen durchsetzte Schicht.

Ein besonders hochwertiger Salzkörper wird erhalten, wenn die Erstarrungsphase einen längeren Zeitraum beansprucht. Nach vollständiger Erstarrung kann jedoch schnell abgekühlt werden, beispielsweise mit 100° pro Stunde, ohne daß im Salzkörper SK Verspannungen und in deren Folge auch Risse zu befürchten sind. Zwischen Salzkörper SK und Gießformauskleidung GFA besteht eine nur geringe Haftung, die während des Abkühlens sofort dazu führt, daß sich die Gießformauskleidung vom Salzkörper SK löst.

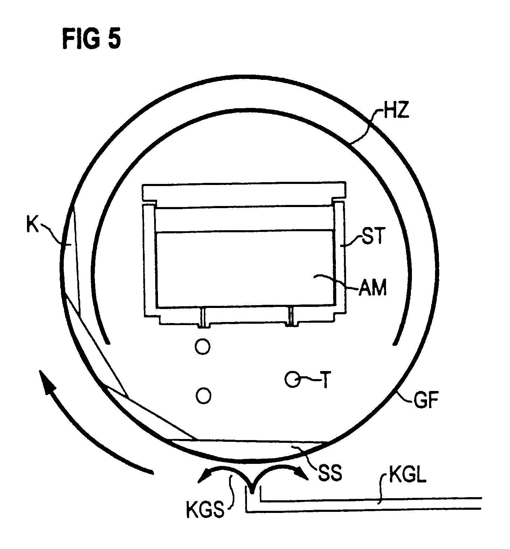

Figur 5 zeigt eine Vorrichtung, mit der stark gekrümmte Salzplatten erzeugt werden können. Dazu ist die Gießform GF als rotierbar gelagerter Hohlzylinder ausgebildet, der in der Figur im Querschnitt senkrecht zur Längsachse des Zylinders dargestellt ist. Die Gießform GF besteht wiederum aus einem gegenüber der Salzschmelze inerten Material oder ist mit einem solchen oberflächlich ausgelegt. Im oberen Bereich der zylinderförmigen Gießform GF in dem die Innenwand nahezu senkrecht oder gar überhängend ist, werden die enstehenden Salzkörper durch einen weiteren unten offenen Hohlzylinder HZ am Herabfallen gehindert. Dieser innere Hohlzylinder weist einen solchen Durchmesser auf, daß zwischen Außenwand des inneren Hohlzylinders HZ und Innenwand der zylinderförmigen Gießform GF gerade ausreichend Platz für die Salzkörper SK verbleibt. Innerhalb der zylinderförmigen Gießform GF ist der Schmelztiegel (V,ST) für die Salzschmelze SS angeordnet.

Durch feine Auslaßöffnungen A im Boden des Schmelztiegels (V,ST) tritt Schmelze aus.

Das Verfahren kann abschnittsweise durchgeführt werden, wobei man die zugeflossene Salzschmelze jeweils weitgehend erstarren läßt, bevor die Gießform um einen gewissen Winkel um die Längsachse gedreht wird. Dabei bilden sich jeweils kreissegmentförmige Salzkörper aus, die man mit dem jeweils nächsten Segment zusammenwachsen läßt.

Möglich ist es auch, die Salzschmelze SS kontinuierlich und langsam zufließen zu lassen. Während der Zugabe der Salzschmelze rotiert die zylinderförmige Gießform GF langsam um ihre Längsachse. Die Rotationsgeschwindigkeit wird dabei so niedrig eingestellt, daß der Füllstand der Salzschmelze in der zylinderförmigen Gießform nicht zu hoch wird.

Ein so entstehender hohlzylinderförmiger Salzkörper kann insbesondere als Szintillator für Ganzkörperaufnahmen in der Radiographie eingesetzt werden. Dazu weist der Zylinder vorzugsweise solche Ausmaße auf, daß er zur Aufnahme eines ganzen menschlichen Körpers oder eines Teils (Kopf) geeignet ist. Beispielsweise kann mit diesem Verfahren ein Salzzylinder von 60 cm Durchmesser und 2 m Länge erzeugt werden.

Nach vollständiger Erstarrung wird auch der Salzzylinder langsam auf Raumtemperatur abgekühlt und entformt. Auch hier wird die Entformung erleichtert, wenn die Gießform aus mehreren Zylindersegmenten zusammengesetzt ist.

In einer nicht dargestellten vorteilhaften Ausgestaltung der Erfindung kann auch die zylinderförmige Gießform GF als vollständig geschlossene Vorrichtung ausgeführt werden, die zur Befüllung mit Inertgas geeignet ist. So können insbesondere hygroskopische Salze verarbeitet bzw. entsprechend hygroskopische Salzplatten hergestellt werden. Eine vollständig geschlossene Vorrichtung kann insbesondere durch nach außen führende Spülgasleitungen ergänzt werden, durch die ein stetiger Inertgasstrom (zum Beispiel trockener Stickstoff) durch die Vorrichtung geblasen werden kann, um ein Eindringen von unerwünschter Feuchtigkeit oder eine Reaktion des Salzes mit Atmosphärenbestandteilen, beispielsweise eine Oxidation des Dotierstoffes, zu verhindern.

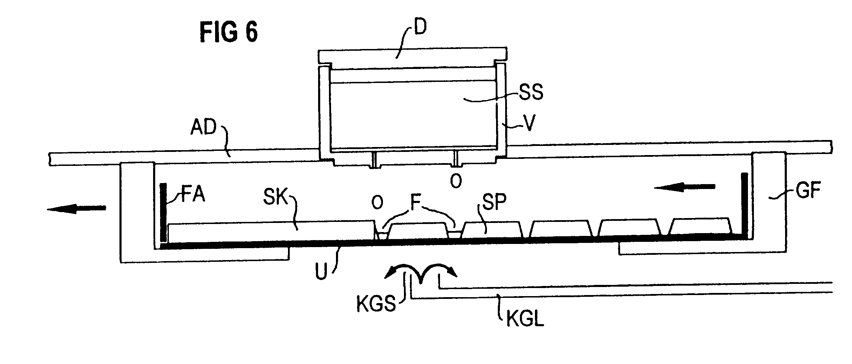

Figur 6 zeigt eine einfache im Prinzip bereits beschriebene Vorrichtung, die zur Durchführung der dritten erfindungsgemäßen Verfahrensvariante geeignet ist. Im wesentlichen besteht die Vorrichtung wiederum aus drei Teilen, nämlich der Gießform GF, dem Schmelztiegel (V,ST) für die Salzschmelze SS und einem Deckel D für den Schmelztiegel (V,ST). Die drei Teile sind so ausgebildet, daß sie formschlüssig übereinander gestapelt werden können und insgesamt eine gasdichte Vorrichtung bilden.

Die Gießform GF ist an den Seitenwänden und am Boden mit einer gegen die Salzschmelze SS inerten Formauskleidung FA versehen. Die Formauskleidung kann aus mehreren Teilen bestehen, beispielsweise aus der Unterlage U und den Seitenteilen. Auf der Unterlage U werden kristalline Salzplatten SP so nebeneinander angeordnet, daß schmale Fugen F zwischen den Salzplatten SP verbleiben. Die Salzplatten können eine beliebige Größe aufweisen und werden durch ein geeignetes herkömmliches Kristallzüchtungsverfahren hergestellt. Beispielsweise werden Einkristalle nach dem Stockbarger-Verfahren hergestellt und durch Zersägen in die entsprechenden Salzplatten zerteilt. Die Dicke der Salzplatten entspricht dabei der gewünschten Dicke des herzustellenden Salzkörpers.

Die Dicke des durch das Verfahren hergestellten Salzkörpers (Rohplatte) wird wegen der Bildung von Lunkern im letzten Stadium der Kristallisation vorzugsweise um bis zu 30% über der angestrebten Dicke des fertigen Werkstücks liegen. Auf jeden Fall sind die Salzplatten jedoch dick genug, daß eine ausreichende mechanische Festigkeit zur sicheren Handhabung gegeben ist und daß die Salzplatten durch den Kontakt mit der später darüberzugießenden Salzschmelze nicht vollständig aufgeschmolzen werden. Gut zu erkennen sind auch die abgeschrägten Seitenkanten der Salzplatten SP. Die dadurch im Querschnitt trapezförmigen Fugen F zwischen den Salzplatten SP weisen an der Unterlage ihre geringste Breite auf.

Die Salzschmelze SS wird aus einem Ausgangsmaterial hergestellt, welches eine für die Anwendung entsprechende Zusammensetzung aufweist. Die Zusammensetzung der Salzschmelze SS muß der Zusammensetzung der Salzkörper SK entsprechen, wenn die Fugen F zwischen den Salzplatten SP nach der Kristallisation der Schmelze optisch nicht mehr in Erscheinung treten dürfen. Durch Verwendung einer Schmelze SS, deren Zusammensetzung von den Salzplatten SP abweicht, lassen sich Salzkörper SK erzeugen, die hinsichtlich ihrer optischen Eigenschaften eine Strukturierung aufweisen. Die übrigen Verfahrensbedingungen werden ähnlich wie im ersten Ausführungsbeispiel (Figuren 1- 4) eingestellt. Die Salzschmelze SS kann direkt im Schmelztiegel (V,ST) erzeugt werden, indem festes Ausgangsmaterial in den Schmelztiegel (V,ST) eingefüllt wird und die Vorrichtung auf eine über dem Schmelzpunkt des Salzes liegende Temperatur aufgeheizt wird, beispielsweise durch Einstellen der Vorrichtung in einen Ofen. Möglich ist es jedoch auch, die Salzschmelze in einem externen Schmelztiegel (nicht dargestellt) zu erzeugen und anschließend in den dann als Vorratsgefäß V ausgestalteten Schmelztiegel einzufüllen.

Der Boden des Schmelztiegels (V,ST) weist schmale Auslaßöffnungen A auf, durch die die Schmelze in feinem Strom in die Gießform GF fließen kann, um dort zunächst die Fugen F aufzufüllen. Eine weitere Möglichkeit besteht darin, die Salzschmelze in einer externen Vorrichtung zu erzeugen und mittels einer geeigneten geheizten Zuleitung direkt in die Gießform einzubringen und über die Salzplatten zu gießen.

In der dargestellten Ausführung besitzt der Schmelztiegel (V,ST) eine kleinere Grundfläche als die Gießform GF. Anordnung der Salzplatten SP und Vorbereitung der Schmelze SS erfolgen wie in der anhand der Figur 1 beschriebenen Vorrichtung jedoch mit dem Unterschied, daß zwischen Gießform GF und der Schmelztiegel (V,ST) eine Relativbewegung durchführbar ist, und daß mit dem Übergießen der Salzplatten SP mit der Salzschmelze SS zunächst an einem Ende der Gießform begonnen wird. Sobald die Fugen F ausgefüllt sind, wird eine durch die dargestellten Pfeile angedeutete Relativbewegung zwischen Schmelztiegel (V,ST) und Gießform GF durchgeführt, um den Schmelztiegel (V,ST) bzw. die Auslaßöffnungen A über noch nicht verfüllten Fugen F anzuordnen.

Nach Verfüllen sämtlicher Fugen entsteht der gewünschte Salzkörper SK, der durch eine Wiederholung des Vorgangs bzw. durch Zugeben weiterer Salzschmelze während einer weiteren Relativbewegung bis zu einer gewünschten Dicke mit Schmelze überschichtet werden kann.

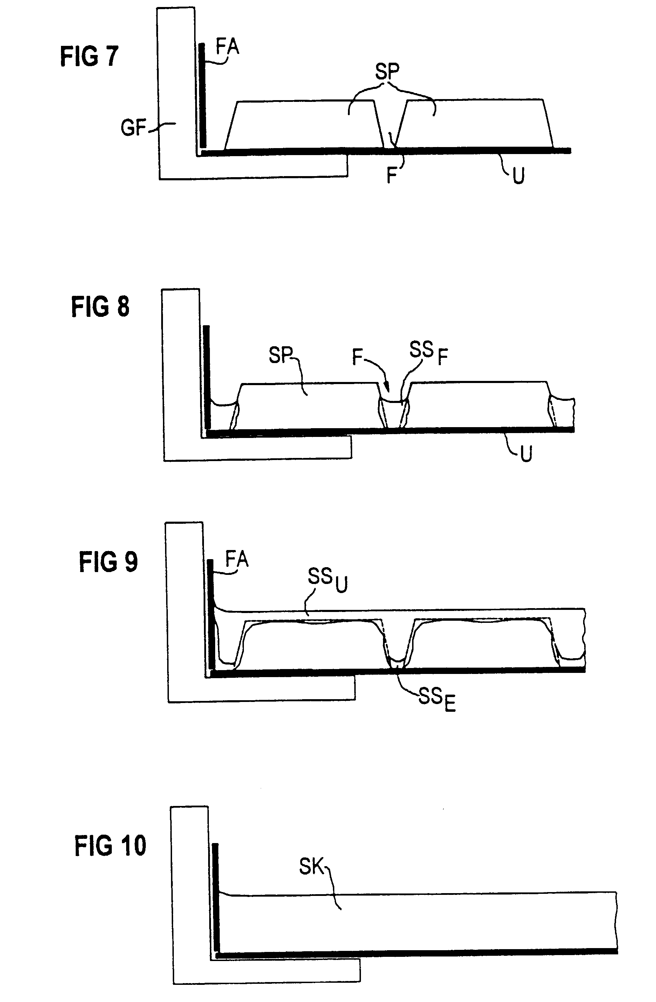

Im folgenden wird der Kristallisationsvorgang des Salzkörpers SK anhand der Figuren 7 bis 10 näher beschrieben, welche einen Teilausschnitt durch die Gießform mit den darin angeordneten Salzkörpern während verschiedener Verfahrensstufen darstellen.

Figur 7 zeigt die Anordnung der Salzplatten SP in der Gießform GF.

Figur 8 zeigt die Anordnung nach dem Zugeben der ersten Teilmenge an Salzschmelze SS. Die Fugen F sind bereits zum Teil mit Salzschmelze SS_{F} gefüllt. Durch die hohe Temperatur der Salzschmelze SS, die ursprünglich 30 bis 60° über deren Erstarrungspunkt liegt, kommt es zunächst zu einem teilweisen Anschmelzen der Salzplatten in den Fugen F. Da die Unterlage durch die Kühlung bei einer Temperatur gehalten wird, die 1° bis 50° unter dem Erstarrungspunkt der Salzschmelze liegt, beginnt die zugeflossene Salzschmelze SS_{F} über dem Boden der Gießform zu kristallisieren und bildet so eine feste Salzkruste aus. Während sich so ein fester durchgehender Salzkörper SK ausbildet, wird weitere Salzschmelze über die Salzplatten SP gegossen, bis die Schmelze SS_{U} soweit über den Salzplatten steht, daß sich keine Lunker in den Fugen bilden können. Durch die überstehende Schmelze SS_{U} kommt es auch hier zu einem oberflächlichen Anschmelzen der Salzplatten.

Figur 9 zeigt die Anordnung, bei der bereits soviel Schmelze SS_{U} zugeführt wurde, daß sie überall die Salzplatten SP bedeckt. Die in den Fugen über der Unterlage bereits auskristallisierte bzw. erstarrte Schmelze SS_{E} verhindert einen weiteren Kontakt der Schmelze mit der Gießform und ein Aufschwimmen der Salzplatten. Auch die Wandbereiche der Formauskleidung FA befinden sich auf einer unter dem Erstarrungspunkt der Schmelze liegenden Temperatur, so daß auch dort die Schmelze beim Kontakt mit der Gießformauskleidung GFA erstarrt.

Figur 10: Durch unveränderte Kühlung der Gießform kommt es schließlich zu einer vollständigen Erstarrung der überstehenden Salzschmelze, wobei sich ein einheitlicher Salzkörper SK ausbildet, der keinerlei Verwerfungen oder sonstige auffällige Korngrenzen entsprechend den ursprünglichen Salzplatten SP aufweist. Außerdem ist er klar und blasenfrei.

Mit dem dargestellten Verfahren können Salzkörper SK von beliebig großer und beliebig geformter Grundfläche hergestellt werden. Das Verfahren ist außerdem von der Art des Salzes bzw. von der Zusammensetzung der Schmelze unabhängig, so daß Salzkörper beliebiger Zusammensetzung hergestellt werden können, sofern sie kubische Kristallstruktur aufweisen und einheitlich aus der Schmelze auskristallisieren. Besonders geeignet ist das Verfahren jedoch zur Herstellung großflächiger Salzplatten, die mit herkömmlichen Verfahren nicht erzeugbar sind. Solche großflächigen Platten aus einem Leuchtstoff, bzw. aus einem mit einem geeigneten Aktivator dotiertem Salz, beispielsweise einem Alkalihalogenid, werden beispielsweise in der Anger-Kamera benötigt. Doch auch undotierte großflächige Salzplatten können wegen ihrer hohen Strahlungsabsorption und optischen Reinheit, die mit dem Verfahren erzielbar ist, als Strahlenschutzfenster eingesetzt werden. Damit ist eine optische Beobachtung von Strahlungsquellen, beispielsweise von radioaktivem Material in "heißen Kammern" möglich. Durch geeignete Ausgestaltung der Gießform können die Salzplatten direkt in der gewünschten Form bzw. mit dem gewünschten Querschnitt hergestellt werden.

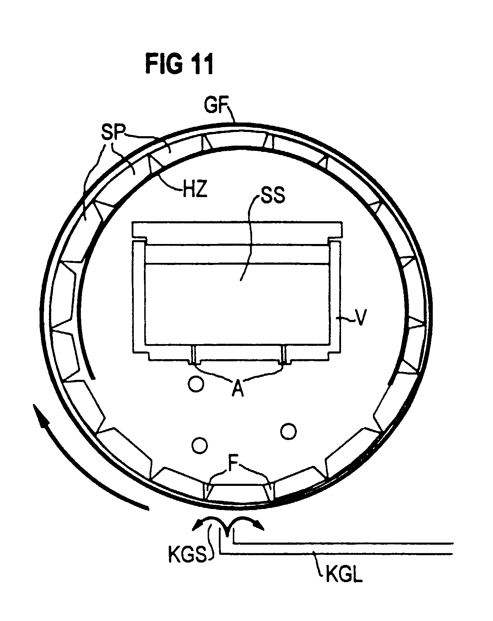

Figur 11 zeigt eine Abwandlung dieser Verfahrensvariante, bei der die anhand Figur 5 beschriebene Vorrichtung verwendet werden kann. Dazu ist die Gießform GF als Hohlzylinder ausgebildet, der in der Figur im Querschnitt senkrecht zur Mittelachse des Zylinders dargestellt ist. Über der Innenwand der hohlzylinderförmigen Gießform werden nun die entsprechend geformten Salzplatten SP angeordnet, bis die gesamte Innenwand der Gießform von diesen bedeckt ist. Um einen guten thermischen Kontakt zwischen den Salzplatten SP und der Form zu erzielen, müssen die Oberflächen der Salzplatten SP entsprechend der Zylinderform gewölbt sein, oder die Innenseite der Form mit ebenen Flächen gestaltet sein. Im oberen Bereich der zylinderförmigen Gießform GF in dem die Innenwand nahezu senkrecht oder gar überhängend ist, werden die Salzplatten bzw. -Körper durch bereits aus Figur 5 bekannten unten offenen Hohlzylinder HZ am Herabfallen gehindert.

Der Schmelztiegel (V,ST) kann auch hier im Innern des Hohlzylinders angeordnet sein. Durch feine Auslaßöffnungen A im Boden des Schmelztiegels (V,ST) tritt Schmelze SS aus und verfüllt die Fugen F zwischen den Salzplatten SP im unteren Bereicn der Gießform GF. Nun wird der Zufluß der Schmelze SS gestoppt, bis die Schmelze zwischen den Fugen erstarrt ist. Anschließend wird die zylinderförmige Gießform GF soweit um ihre Mittelachse gedreht, bis die nächsten unverfüllten Fugen unterhalb der Auslaßöffnungen A zu liegen kommen. Danach läßt man weitere Schmelze zufließen und erstarren. Durch weitere Rotation der Gießform und Wiederholen des Vorgangs werden schließlich sämtliche Fugen F der auf der Innenwandung der zylinderförmigen Gießform GF angeordneten Salzplatten SP verfüllt und verfestigt. Möglich ist es auch, die Salzschmelze SS kontinuierlich und langsam zufließen zu lassen und dabei die zylinderförmige Gießform GF ebenfalls langsam rotieren zu lassen, so daß die zugegossene Schmelze in den Fugen ausreichend schnell erstarrt, bis alle Fugen verfüllt sind.

In einer nicht dargestellten vorteilhaften Ausgestaltung der Erfindung kann auch die zylinderförmige Gießform GF als vollständig geschlossene Vorrichtung ausgeführt werden, die zur Befüllung mit Inertgas geeignet ist.

## Patentansprüche

1. Verfahren zur Herstellung eines polykristallinen Salzkörpers (SK) mit den Schritten
- Erzeugen einer Salzschmelze (SS) durch Aufschmelzen eines Ausgangsmaterials (AM) mit einer für den Salzkörper vorgesehenen Zusammensetzung in einem gegen die Salzschmelze inerten Schmelztiegel (ST)
- Einbringen der Salzschmelze in eine Gießform (GF), bei der zumindest deren Boden durch eine Kühlung des Bodens auf einer Temperatur gehalten wird, die 1-50°C unter dem Erstarrungspunkt der Salzschmelze liegt, wobei sich unmittelbar eine feste Salzkruste (K) auf dem Boden der Gießform ausbildet,
- Halten der Gießform bei einer Temperatur unter dem Erstarrungspunkt, bis die überstehende Salzschmelze vollständig zum polykristallinen Salzkörper (SK) erstarrt ist und
- Abkühlen des Salzkörpers.

2. Verfahren nach Anspruch 1,
bei dem das Einbringen der Salzschmelze (SS) kontinuierlich mit dem Aufschmelzen erfolgt.

3. Verfahren nach Anspruch 1 oder 2,
bei dem vor dem Einbringen der Salzschmelze (SS) am Boden der Gießform (GF) zumindest zwei kristalline block- oder plattenförmige Salzplatten (SP), die eine den Salzkörpern entsprechende Zusammensetzung aufweisen, nebeneinander derart angeordnet werden, daß Fugen (F) von geringer Breite dazwischen verbleiben, und bei dem die Salzplatten (SP) mit der Salzschmelze (SS) übergossen werden, bis zumindest die Fugen mit Salzschmelze gefüllt sind.

4. Verfahren nach Anspruch 3,
bei dem der Boden der Gießform (GF) auf einer Temperatur gehalten wird, die 5 - 50°C unter dem Erstarrungspunkt der Salzschmelze liegt.

5. Verfahren nach einem der Ansprüche 1 bis 4,
- bei dem eine Vorrichtung verwendet wird, die aus einer Gießform (GF) und einem Schmelztiegel (V,ST) für das Ausgangsmaterial (AM) besteht,
- bei dem der Schmelztiegel(V,ST) im Boden feine Auslaßöffnungen (A) für die Salzschmelze (SS) aufweist und zusammen mit der Gießform (GF) eine geschlossene Vorrichtung bildet, in der es mit dieser durch Druckausgleichskanale (GD) verbunden ist ,
- bei dem das Heizen der Salzschmelze durch Einstellen der gesamten Vorrichtung in einen Ofen erfolgt, der auf einer über dem Schmelzpunkt des Ausgangsmaterials (AM) liegenden Temperatur gehalten wird,
- bei dem das Einbringen der Salzschmelze kontinuierlich mit dem Aufschmelzen des Ausgangsmaterials (AM) durch die Auslaßöffnungen (A) erfolgt
- und bei dem die Kühlung des Bodens der Gießform (GF) durch ein von unten dagegen gerichtetes Kühlgebläse (KGL,KGS) bewirkt wird.

6. Verfahren nach einem der Ansprüche 1 bis 5,
bei dem während des Einbringens der Salzschmelze (SS) eine Relativbewegung zwischen dem Schmelztiegel(V,ST) und der Gießform (GF) durchgeführt wird.

7. Verfahren nach einem der Ansprüche 1 bis 6,
bei dem als Gießform (GF) ein Hohlzylinder verwendet wird, der während des Einbringens der Salzschmelze (SS) um seine Längsachse rotiert.

8. Verfahren nach einem der Ansprüche 1 bis 7,
bei dem Aufschmelzen des Ausgangsmaterials (AM) und Halten und Abkühlen der Salzschmelze (SS) unter einer Schutzgasatmosphäre durchgeführt werden.

9. Verfahren nach einem der Ansprüche 1 bis 8,
bei dem Salzplatten (SP) mit zumindest zu den Fugen (F) hin abgeschrägten Kanten verwendet werden, so daß die Auflagefläche der Salzplatten (SP) in der Gießform (GF) größer ist als deren gegenüberliegende Oberfläche.

10. Vorrichtung zum Herstellen großflächiger polykristalliner Salzkörper (SK)
- mit einer inert ausgekleideten Gießform (GF),
- mit einem über oder innerhalb der Gießform angeordneten Schmelztiegel(V,ST) für die Salzschmelze (SS), welcher im Bodenbereich feine Auslaßöffnungen (A) aufweist,
- bei der der Schmelztiegel mit der Gießform zusammen ein geschlossenes System mit Druckausgleichskanälen bildet und
- bei der Kühlgasleitungen (KGL) zur Kühlung des Bodens der Gießform mit einem Kühlgasstrom (KGS) vorgesehen sind und
- die zum Betrieb in einen Ofen einstellbar ist.

11. Vorrichtung nach Anspruch 10,
bei dem die Gießform (GF) zerlegbar ausgebildet ist und zumindest aus einem die Unterlage (U) bildenden Bodenteil und einem Wandteil (FA) besteht.

12. Vorrichtung nach einem der Ansprüche 10 oder 11,
welche nach außen führende Spülgaskanäle aufweist.

13. Vorrichtung nach einem der Ansprüche 10 bis 12,
bei der die Gießform (GF) als rotierbarer Hohlzylinder ausgebildet ist, in dem der Schmelztiegel(V,ST)angeordnet ist.

14. Vorrichtung nach einem der Ansprüche 10 bis 12,
bei der der Schmelztiegel(V,ST) außerhalb der Gießform (GF) angeordnet ist.

15. Vorrichtung nach einem der Ansprüche 10 bis 14,
bei dem der Schmelztiegel(V,ST) und Gießform (GF) mit Glaskohlenstoff (GFA,FA) oder einem Edelmetall (GFA,FA) ausgekleidet sind.

16. Verwendung des Verfahrens und der Vorrichtung nach einem der vorangehenden Ansprüche zur Herstellung von Szintillatorplatten zur Detektion von Gammastrahlung, insbesondere für die Anger-Kamera.

17. Verwendung des Verfahrens nach Anspruch 1 bis 9 zur Herstellung von großflächigen Sicht fenstern, die zum Abschirmen hochenergetischer Strahlung geeignet sind.

## Claims

1. Process for the production of a polycrystalline salt body (SK) with the steps
- production of a salt melt (SS) by melting a starting material (AM) with a composition intended for the salt body in a melting crucible (ST) which is inert towards the salt melt,
- introduction of the salt melt into a casting mould (GF) in which at least its base is kept, by cooling of the base, at a temperature which is 1-50°C below the solidification point of the salt melt, there being direct formation of a solid salt crust (K) on the base of the casting mould,
- maintenance of the casting mould at a temperature below the solidification point until the supernatant salt melt has solidified completely to the polycrystalline salt body (SK) and
- cooling of the salt body.

2. Process according to Claim 1, in which the introduction of the salt melt (SS) takes place continuously with the melting.

3. Process according to Claim 1 or 2, in which, before introduction of the salt melt (SS), at least two crystalline salt plates (SP) which are in block or plate form and have a composition corresponding to the salt bodies are arranged side by side on the base of the casting mould (GF) in such a way that gaps (F) of small width remain between them, and in which the salt melt (SS) is poured over the salt plates (SP) until at least the gaps are filled with salt melt.

4. Process according to Claim 3, in which the base of the casting mould (GF) is kept at a temperature which is 5-50°C below the solidification point of the salt melt.

5. Process according to any of Claims 1 to 4,
- in which a device which consists of a casting mould (GF) and a melting crucible (V,ST) for the starting material (AM) is used,
- in which the melting crucible (V,ST) has in the base fine outlet openings (A) for the salt melt (SS) and forms together with the casting mould (GF) a closed device in which it is connected to the latter by pressure equalization channels (GD),
- in which the heating of the salt melt is effected by placing the entire device in an oven which is kept at a temperature above the melting point of the starting material (AM),
- in which the introduction of the salt melt takes place continuously with the melting of the starting material (AM) through the outlet openings (A)
- and in which the cooling of the base of the casting mould (GF) is brought about by a cooling blower (KGL,KGS) directed onto it from below.

6. Process according to any of Claims 1 to 5, in which a relative movement between the melting crucible (V,ST) and the casting mould (GF) is carried out during the introduction of the salt melt (SS).

7. Process according to any of Claims 1 to 6, in which a hollow cylinder which is rotated around its long axis during the introduction of the salt melt (SS) is used as casting mould (GF).

8. Process according to any of Claims 1 to 7, in which the melting of the starting material (AM) and maintenance and cooling of the salt melt (SS) are carried out under an atmosphere of protective gas.

9. Process according to any of Claims 1 to 8, in which salt plates (SP) with edges which slope at least towards the gaps (F) are used so that the support area of the salt plates (SP) in the casting mould (GF) is larger than the surface area opposite thereto.

10. Device for the production of large-area polycrystalline salt bodies (SK)
- having a casting mould (GF) with an inert lining,
- having a melting crucible (V,ST), which is located above or within the casting mould and has in the base region fine outlet openings (A), for the salt melt (SS),
- in which the melting crucible forms together with the casting mould a closed system with pressure equalization channels, and
- in which cooling gas lines (KGL) are provided for cooling the base of the casting mould with a stream of cooling gas (KGS), and
- which can be placed in a furnace for operation.

11. Device according to Claim 10, in which the casting mould (GF) is designed so that it can be taken apart and consists at least of a base part forming the base (U) and of a wall part (FA).

12. Device according to either of Claims 10 or 11, which has flushing gas channels leading to the outside.

13. Device according to any of Claims 10 to 12, in which the casting mould (GF) is designed as rotatable hollow cylinder in which the melting crucible (V,ST) is located.

14. Device according to any of Claims 10 to 12, in which the melting crucible (V,ST) is located outside the casting mould (GF).

15. Device according to any of Claims 10 to 14, in which the melting crucible (V,ST) and casting mould (GF) are lined with glassy carbon (GFA,FA) or a noble metal (GFA,FA).

16. Use of the process and of the device according to any of the preceding claims for the production of scintillator plates for the detection of gamma rays, in particular for the Anger camera.

17. Use of the process according to Claim 1 to 9 for the production of large-area inspection windows which are suitable for shielding high-energy radiation.

## Revendications

1. Procédé de fabrication d'un corps de sel polycristallin (SK), comportant les étapes suivantes :
- production d'un sel fondu (SS) par fusion d'une matière de départ (AM) de composition adaptée au corps de sel dans un creuset (ST) inerte par rapport au sel fondu,
- introduction du sel fondu dans un moule (GF) dont au moins le fond est maintenu, par refroidissement du fond, à une température de 1 à 50°C inférieure au point de solidification du sel fondu, une croûte de sel (K) solide se formant aussitôt sur le fond du moule,
- maintien du moule à une température inférieure au point de solidification, jusqu'à ce que le sel fondu surnageant soit complètement solidifié en corps de sel polycristallin (SK), et
- refroidissement du corps de sel.

2. Procédé selon la revendication 1, dans lequel l'introduction du sel fondu (SS) se fait continûment pendant la fusion.

3. Procédé selon la revendication 1 ou 2, dans lequel, avant l'introduction du sel fondu (SS), on dispose au fond du moule (GF), l'une à côté de l'autre, au moins deux plaques de sel cristallin (SP) en forme de bloc ou de plaque, dont la composition correspond à celle des corps de sel, de manière à conserver entre elles des fentes (F) de faible largeur, et dans lequel on coule sur les plaques de sel (SP) le sel fondu (SS), jusqu'à ce qu'au moins les fentes soient remplies de sel fondu.

4. Procédé selon la revendication 3, dans lequel on maintient le fond du moule (GF) à une température de 5 à 50°C inférieure au point de solidification du sel fondu.

5. Procédé selon l'une des revendications 1 à 4,
- dans lequel on utilise un dispositif constitué par un moule (GF) et un creuset (V, ST) pour la matière de départ (AM),
- dans lequel le creuset (V, ST) présente dans le fond de fins orifices de sortie (A) pour le sel fondu et forme ensemble avec le moule (GF) un dispositif fermé, dans lequel il communique avec celui-ci par des canaux de compensation de pression (GD),
- dans lequel on chauffe le sel fondu, par réglage de l'ensemble du dispositif, dans un four maintenu à une température supérieure au point de fusion de la matière de départ (AM),
- dans lequel l'introduction du sel fondu se fait continûment, pendant la fusion de la matière de départ (AM), à travers les orifices de sortie (A), et
- dans lequel le refroidissement du fond du moule (GF) est obtenu par une soufflante de refroidissement (KGL, KGS) dirigée par le bas contre celui-ci.

6. Procédé selon l'une des revendications 1 à 5, dans lequel, pendant l'introduction du sel fondu (SS), on effectue un mouvement relatif entre le creuset (V, ST) et le moule (GF).

7. Procédé selon l'une des revendications 1 à 6, dans lequel on utilise comme moule (GF) un cylindre creux qui, pendant l'introduction du sel fondu (SS), tourne autour de son axe longitudinal.

8. Procédé selon l'une des revendications 1 à 7, dans lequel la fusion de la matière de départ (AM) et le maintien et le refroidissement du sel fondu (SS) se font en atmosphère inerte.

9. Procédé selon l'une des revendications 1 à 8, dans lequel on utilise des plaques de sel (SP) dont les bords sont inclinés au moins vers les fentes (F), de manière à ce que la surface d'appui des plaques de sel (SP) dans le moule soit plus grande que leur surface opposée.

10. Dispositif de fabrication de corps de sel polycristallin (SK) à large surface
- comportant un moule (GF) muni d'un revêtement inerte,
- comportant un creuset (V, ST) pour le sel fondu (SS), disposé au-dessus ou à l'intérieur du moule, qui présente au niveau du fond de fins orifices de sortie (A),
- dans lequel le creuset forme ensemble avec le moule un système fermé pourvu de canaux de compensation de pression et
- dans lequel des conduites de gaz de refroidissement (KGL) destinées à refroidir le fond du moule à l'aide d'un flux de gaz de refroidissement (KGS) sont prévues et
- qui en vue de l'exploitation peut être placé dans un four.

11. Dispositif selon la revendication 10, dans lequel le moule (GF) est réalisé de manière démontable et constitué au moins par un élément de fond formant le support (U) et un élément de paroi (FA).

12. Dispositif selon l'une des revendications 10 ou 11, lequel présente des canaux de gaz de rinçage menant vers l'extérieur.

13. Dispositif selon l'une des revendications 10 à 12, dans lequel le moule (GF) est réalisé sous forme de cylindre creux qui peut être mis en rotation et dans lequel est disposé le creuset (V, ST).

14. Dispositif selon l'une des revendications 10 à 12, dans lequel le creuset (V, ST) est disposé en dehors du moule (GF).

15. Dispositif selon l'une des revendications 10 à 14, dans lequel le creuset (V, ST) et le moule (GF) sont revêtus de vitrocarbone (GFA, FA) ou d'un métal précieux (GFA, FA).

16. Utilisation du procédé et du dispositif selon l'une des revendications précédentes pour la fabrication de plaques de scintillateur permettant la détection de rayons gamma, en particulier pour la caméra d'Anger.

17. Utilisation du procédé selon la revendication 1 à 9 pour la fabrication de fenêtres à large surface aptes à servir d'écrans contre le rayonnement hautement énergétique.
